(19) Europäisches Patentamt
European Patent Office
Office européen des brevets

(11) **EP 1 637 238 A1**

(12) **EUROPEAN PATENT APPLICATION**

(43) Date of publication:
**22.03.2006 Bulletin 2006/12**

(51) Int Cl.:
*B08B 3/12* (2006.01)   *B01J 19/10* (2006.01)
*H01L 21/00* (2006.01)

(21) Application number: **04447204.1**

(22) Date of filing: **21.09.2004**

(84) Designated Contracting States:
**AT BE BG CH CY CZ DE DK EE ES FI FR GB GR
HU IE IT LI LU MC NL PL PT RO SE SI SK TR**
Designated Extension States:
**AL HR LT LV MK**

(71) Applicants:
• **INTERUNIVERSITAIR MICROELEKTRONICA
CENTRUM VZW**
**3001 Leuven (BE)**
• **SAMSUNG ELECTRONICS CO. LTD.**
**Yongin-City,**
**Gyec (KR)**

(72) Inventors:
• **Holsteyns , Frank**
**B-1030 Schaarbeek (BE)**
• **Lee, Kuntack**
**B-3001 Leuven (BE)**

(74) Representative: **Bird, Ariane et al**
**Bird Goën & Co**
**Klein Dalenstraat 42A**
**3020 Winksele (BE)**

(54) **Method for controlled cavitation**

(57)   The invention relates to a method for creating cavitation comprising the steps of creating gas bubbles having a range of bubble sizes in a liquid, creating an acoustic field and subjecting the liquid to the acoustic field, characterized in that the range of bubble sizes and/or the characteristics of the acoustic field are selected to tune them to each other, thereby controlling cavitation in the selected range of bubble sizes. It also relates to an apparatus suitable for performing the method according to the invention.

Figure 7

**Description**

**Field of the invention**

The invention relates to a method for creating and controlling cavitation in a liquid. The method may be applied in a wide range of applications including cleaning, e.g. cleaning of medical apparatus, cleaning of flat substrates such as wafers in the semiconductor industry, etc.
It also relates to an apparatus suitable for creating and controlling cavitation in a liquid, especially to cleaning apparatus.

**Background of the invention**

Cavitation is generally known and defined as the formation and activity of bubbles in a liquid. This bubble activity comprises bubble growth, pulsation or collapse.
Cavitation is applied in a large number of technical fields. In sonochemistry, bubbles collapsing in an ultrasonic field have a catalytic effect on chemical reactions. Also in medical applications cavitation is used, for example as contrast enhancer in ultrasound diagnostics. Probably the best-known application of cavitation is the removal of particles from a surface of a substrate.
A common problem in these various applications is how to control this cavitation phenomenon such that it performs in a controlled uniform way with respect to location, appearance of collapse or pulsation, etc.
For example, in cleaning technology today, a common problem is non-uniform removal of particles from the surface of a substrate. The particles have to be removed without damaging the substrate by heavy collapse and nevertheless leaving a uniform cleaned surface.
The particle removal mechanism was studied earlier either by gasifying with gasses like oxygen, nitrogen, argon, xenon, carbon dioxide, etc., or by degassing the liquid to get ultra pure wafer and then looking at the sonoluminescence (SL) signal generated by collapsing bubbles and the particle removal efficiency.

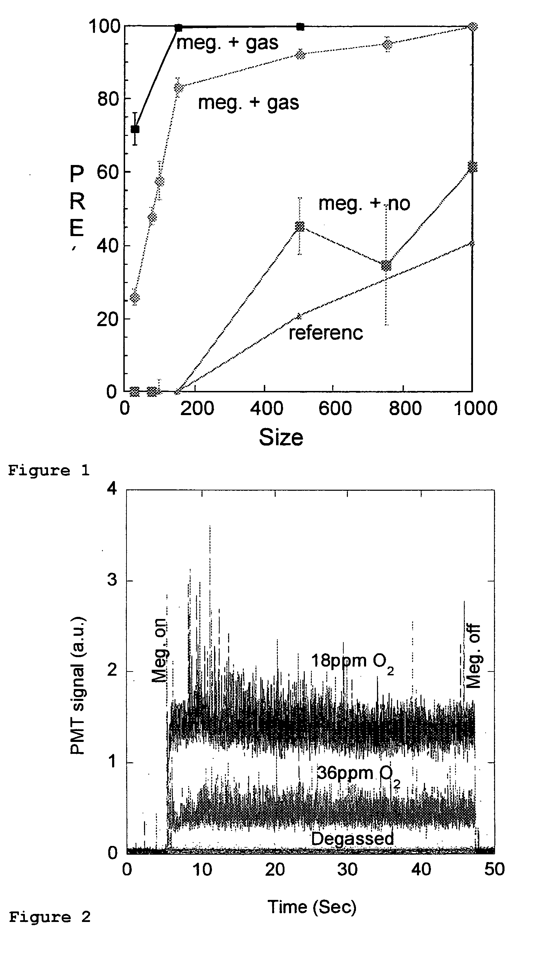

In figure 1 is shown that the presence of gas in the liquid is necessary to achieve high particle removal efficiency (PRE). In figure 2 the SL signal is plotted for gasified and degassed liquid. In gasified liquids an SL signal, generated by collapsing bubbles, can be detected contrary to degassed liquid. The combination of both figures pointed out that gaseous cavitation is on the basis of the particle removal mechanism.

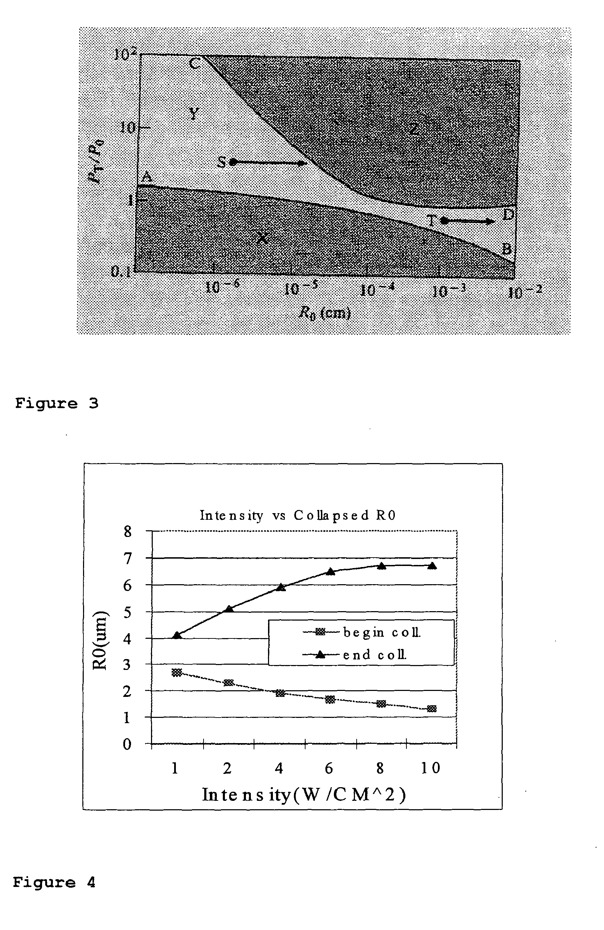

In figure 3, Neppiras (Acoustic Cavitation, 1980) shows that dependent on the driving pressure and the frequency of the acoustic field and dependent on the gas bubble radius, the gas bubble can grow (zone Y) and then collapse when entering area Z, or can dissolve again, if small enough to enter zone X.
In US6048405 Skrovan teaches a cleaning method for microelectronics industry introducing gas bubbles below the surface of the substrate such that the bubbles pass across the surface as they rise in the liquid and immersing the surface in a particular region through which megasonic energy is projected. However, Skrovan claims the particles are released from the surface by shockwaves from the megasonic field and not by shockwaves from gas bubble collapse. However, figure 1 proofs that the use of only megasonic energy is not efficient at all compared to gasified liquid in combination with megasonic energy. Moreover, this document does not teach how to control cavitation and when applying this method, a non-uniform cleaning will be obtained.

**Summary of the invention**

In a first aspect the invention provides a method for creating cavitation comprising the steps of

- creating gas bubbles having a range of bubble sizes in a liquid
- creating an acoustic field and
- subjecting the liquid to the acoustic field,
  characterized in that the range of bubble sizes and/or the characteristics of the acoustic field are selected to tune them to each other, thereby controlling cavitation in the selected range of bubble sizes.

The liquid can be any of, or any combination of an aqueous solution, an organic, inorganic, polar or nonpolar solvent, a mixture of chemicals or any fluid in which a gas can be dissolved or injected. The method can be used in any cleaning application, e.g. for medical equipment or for wafers in the semiconductor industry.
The characteristics of the acoustic field to be selected can be any of, or any combination of, the frequency, the intensity, the position of the transducer or transducers, or any parameter affecting the acoustic field.
In an embodiment of the invention, the range of bubble sizes can be selected subsequent to and depending on the selection of the characteristics of the acoustic field. If the characteristics of the acoustic field are fixed or the selection of it is limited, the range of bubble sizes can be adjusted.

In a further embodiment of the invention, the characteristics of the acoustic field are selected subsequent to and depending on the selected range of bubble sizes. If the range of bubble sizes is fixed or the selection of it is limited, the characteristics of the acoustic field can be adjusted.

In an embodiment of the invention, the step of creating gas bubbles having a selected range of bubble sizes comprises dissolving gas in the liquid by means of a gasification unit or any other means to dissolve gas in the liquid.

In an embodiment of the invention, the step of creating gas bubbles having a selected range of bubble sizes comprises injection of gas in the liquid by means of a bubbler system, a capillary, a nozzle, a membrane contactor or any means to inject gas bubbles into the liquid.

In an embodiment of the invention, the step of creating gas bubbles having a selected range of bubble sizes comprises applying a pressure drop, preferably a rapid pressure drop or comprises applying one or multiple compression/ decompression cycles.

In an embodiment of the invention, the step of creating gas bubbles having a selected range of bubble sizes comprises a raise in temperature or comprises one or multiple cycles of heating/cooling the liquid.

In an embodiment of the invention, the step of creating gas bubbles having a selected range of bubble sizes comprises a step of subjecting the liquid to an additional acoustic field.

In an embodiment of the invention, the step of creating gas bubbles having a selected range of bubble sizes comprises dissolving or injecting two or more different gasses into the liquid.

In an embodiment of the invention, the step of creating gas bubbles having a selected range of bubble sizes comprises adding a surfactant to the liquid.

In an embodiment of the invention, the range of bubble sizes is varied over time.

In an embodiment of the invention, the acoustic field comprises one or more frequencies.

An embodiment of the invention can further comprise the step of measuring the range of bubble sizes.

An embodiment of the invention can further comprise the step of controlling the characteristics of the acoustic field subsequently to and dependent on the measurement of the range of bubble sizes.

An embodiment of the invention can further comprise the step of controlling the range of bubble sizes subsequently and dependent on the measurement of the range of bubble sizes.

In a second aspect, the invention provides an apparatus comprising

- means for creating gas bubbles having a range of bubble sizes in a liquid,
- means for creating an acoustic field and
- means for subjecting the liquid to the acoustic field,
  characterized in that the means for creating the gas bubbles having a range of bubble sizes and/or the means for creating the acoustic field are adaptedto tune the range of bubble sizes and the characteristics of the acoustic field to each other, thereby controlling cavitation in the selected range of bubble sizes.

In apparatus according to the invention, the means for creating gas bubbles having a range of bubble sizes may comprise a gasification unit or any means to dissolve gas in the liquid.

In an apparatus according to the invention, the means for creating gas bubbles having a range of bubble sizes may comprise a valve, a nozzle, a membrane contactor or any means to inject gas bubbles in the liquid.

In an apparatus according to the invention, the means for creating gas bubbles having a range of bubble sizes may comprise a heat exchanging system or any means for heating/cooling the liquid.

In an apparatus according to the invention, the means for creating gas bubbles having a range of bubble sizes may comprise any means for generating a pressure drop or generating one or multiple compression/decompression cycles.

In an apparatus according to the invention, the means for creating gas bubbles having a range of bubble sizes may comprise means to create an additional acoustic field and to subject the liquid to the additional acoustic field.

In an apparatus according to the invention, the means for creating gas bubbles having a range of bubble sizes may comprise means for dissolving or injecting two or more different gasses into the liquid.

In an apparatus according to the invention, the means for creating gas bubbles having a range of bubble sizes may comprise means for adding a surfactant to the liquid.

In an apparatus according to the invention, the means for creating an acoustic field may be capable of generating one or more frequencies.

An apparatus according to the invention can further comprise a measurement unit for measuring the range of bubble sizes.

An apparatus according to the invention can further comprise a control unit for controlling the means for creating gas bubbles having a range of bubble sizes and/or controlling the means for creating an acoustic field.

**Short description of the drawings**

Figure 1 : PRE as a function of particle size and gas concentration in the liquid.

Figure 2 : SL signal as a function of time and gas concentration in the liquid.

Figure 3 : Behavior of a gas bubble in a liquid as a function of acoustic field characteristics and bubble size.

Figure 4 : Collapse as a function of bubble size and acoustic field characteristics.

Figure 5 : Maximum temperature and pressure during collapse as a function of frequency.

Figure 6 : Set-up with 2 pluralities of transducers which can be used with the present invention.

Figure 7 : Process flow of a particular set-up which can be used with the present invention.

Figure 8 : Schematic of a spray nozzle.

Figure 9 : PRE for 1.8 MHz, 5 W/cm$^2$, 2.5 bar overpressure, 18 ppm oxygen.

Figure 10 : PRE for 1.8 MHz, 5 W/cm$^2$, 2.5 bar overpressure, 10 ppm oxygen.

**Detailed description of the invention**

The present invention relates to methods and apparatus for creating cavitation in a liquid. Such methods and apparatus can be used for cleaning purposes, e.g. in medical applications where sterilization is required, or in the semiconductor industry for cleaning wafers. The invention will be described in certain embodiments and with reference certain drawings, however these are for explanation purposes only.

In order to control cavitation in a liquid and solve the problem of non-uniform performance of cavitation, a method is disclosed to generate a specific bubble distribution and bringing these bubbles into a specific acoustic field.

This method comprises 3 steps: creating gas bubbles having a range of bubble sizes in a liquid, creating an acoustic field, and subjecting the liquid to the acoustic field, wherein the range of bubble sizes and/or the characteristics of the acoustic field are selected to tune them to each other, thereby controlling cavitation in the selected range of bubble sizes.

Creating bubbles in the liquid can be done in different ways. First of all, addition of gas to the liquid is needed. Gases like nitrogen, oxygen, carbon dioxide, argon, helium, Xenon, etc. can be added to the liquid by a gasification unit, e.g. a membrane contactor. The ambient pressure of the liquid, the hydrostatic pressure of the liquid, the vapor pressure of the gas, the liquid flow, the liquid temperature and the contact area between gas and liquid are the main parameters to control the amount of gas dissolved in the liquid. Most of the gas will be present in the dissolved state. The higher the pressure of the liquid and the lower the temperature the more gas can be dissolved in the liquid. The amount and the saturation level of the gas dissolved will have an influence on the bubble formation.

Bubble formation out of the dissolved gas can be obtained by one or multiple compression and decompression cycles. This can be done by using a pressure-releasing valve to obtain a pressure drop in the tank after compression. Also a valve, an orifice or a membrane between two tank compartments of which one is at higher pressure than the second one can supply a pressure drop, thereby creating gas bubbles in the second compartment. Controlling the pressure difference and optionally the speed of cycles of compression/decompression is a way to control the amount and size of the gas bubbles. Another way to create bubbles out of dissolved gas is a raise in temperature by a heat exchanging system. The temperature shift is then the main parameter to determine the size of the bubbles.

Acoustic energy can also create bubbles in a liquid out of dissolved gas, because acoustic energy waves are pressure waves causing compression/decompression cycles.

Instead of forming bubbles out of dissolved gas, immediate injection of bubbles in the liquid can be applied. A bubbler system, a capillary, a nozzle, etc. can inject gas bubbles in the liquid. Also a membrane contactor with a dedicated pore size, separating the liquid from the supplied gas, can be used.

In general, the design of the hardware, the amount of gas present, the decompression rate, the temperature shift, the presence of surface-active agents (e.g. surfactants), etc. will determine the final size of the bubbles present in the liquid. The smallest bubbles will disappear again as dissolved gas and the bigger bubbles will grow. The critical size, determining either growth or disappearance, will be affected by the vapor pressure in the liquid, the ambient pressure of the liquid and the surface tension.

A few techniques to measure bubble sizes are available, for example light-scattering and sound dispersion.

In the light-scattering method, a laser beam is directed through a cell wherein a liquid containing gas bubbles is flowing in a continuous way perpendicular to the laser beam. A bubble crossing the laser beam causes light-scattering which is detected by a photodiode connected to an oscilloscope. The laser beam itself is blocked by a beam stopper after crossing the cell. The intensity of the light-scattering signal is a measure for the bubble size and is calibrated by means of latex sphere equivalent sizes. Optionally, this method is applicable in an acoustic field.

In the sound dispersion method, a transmitter is sending a signal towards a receiver in a fluid medium containing gas bubbles. The bubbles present in the fluid influence the attenuation and the group velocity of the signal. These two parameters can be calibrated as a measure for gas bubble size and number of bubbles. However, this method is not applicable in an acoustic field because of the influence of the acoustic waves on the signal.

The created gas bubbles or at least a part of it are subjected to an acoustic field with a typical acoustic pressure and a typical frequency, causing a particular bubble activity: growth, pulsation or collapse of bubbles. All bubbles are active but not all of them will collapse. Only bubbles with a particular distribution of bubble size will collapse, which is described by the Rayleigh-Plesset model. The following equation describes the adiabatic collapse of a gas bubble in a liquid:

$$\rho(R\ddot{R}+\frac{3}{2}\dot{R}^2) = P_g(R) - P_0 - P_a(t) + \frac{R}{c}\frac{d}{dt}\left[P_g(R) - P_a(t)\right] - 4\eta\frac{\dot{R}}{R} - \frac{2\sigma}{R}$$

wherein R is the bubble radius, $\rho$ is the liquid density, $P_g$ is the vapor pressure, $P_o$ is the ambient hydrostatic pressure, $P_a$ is the time dependent driving pressure, c is the speed of the acoustic waves in the liquid, $\eta$ is the liquid viscosity and $\sigma$ is the liquid surface tension. The driving pressure is dependent of the frequency and intensity of the acoustic field.

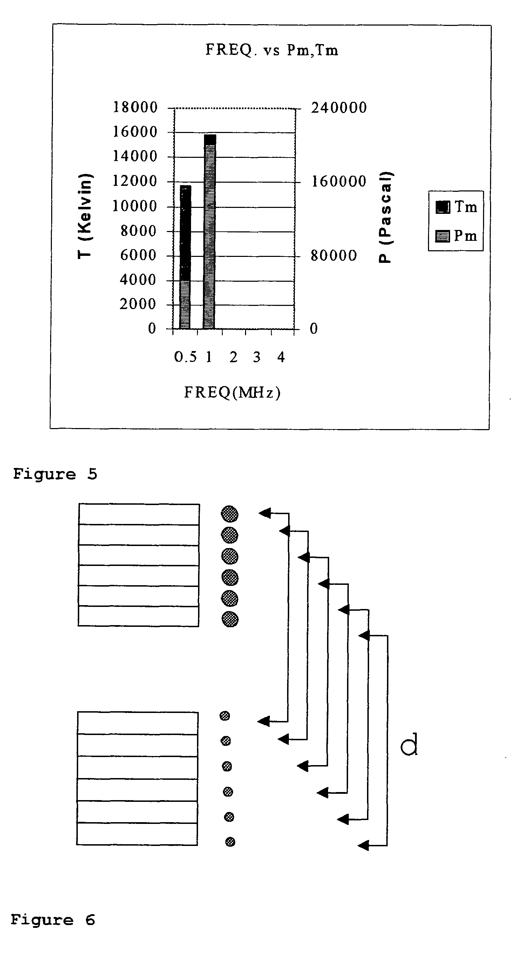

In case of particle removal, collapsing bubbles cause micro-streaming and shockwaves resulting in the creation of a drag force over the particles present on the surface. If these forces can overcome the Vanderwaals and Electrostatic forces these particles can be removed. In order to obtain a maximum quantity of micro-streaming and shockwaves in the liquid, as much as possible gas bubbles must collapse nearby the surface of the substrate. Theoretical calculations and experimental data showed that only a specific range of bubble sizes collapse in a specific acoustic field. In figure 4 is shown that bubbles that are smaller than a minimum bubble size or bigger than a maximum bubble size do not collapse in an acoustic field with a particular intensity and a particular frequency, in this case 1 MHz. In figure 5 is shown that the maximum pressure Pm and the maximum temperature Tm during bubble collapse is dependent on the frequency of the acoustic field. When generating the appropriate bubble size in a particular acoustic field, cavitation can thus be controlled. In case of cleaning, the process conditions can be optimized in order to obtain a uniform particle removal and reduce the amount of damage on the surface by controlling violently collapsing bubbles.

In the general scope of this invention, the gas bubble size in the region where the acoustic field is provided and the specifications of the acoustic field have to be geared to each other in order to have a uniform cavitation in that region. Thus, if on the one hand for particular reasons the useful range of gas bubble size is limited, the acoustic field has to be adjusted obtaining the desired cavitation. If on the other hand limitations on the specifications of the acoustic field have to be taken in account, the range and distribution of bubble size have to be adjusted.

A way to optimize the uniformity of cavitation in a tank is tuning the range of bubble size at the bottom of the tank by tuning the design of the valve, the orifice, the membrane contactor, etc. The bubbles will grow as they rise in the tank and will have the desired range of size when entering the acoustic field. Besides the initial size of the generated bubbles, the depth of generation, the depth of the tank and the position of the acoustic field can be varied in this case. The liquid flow speed and orientation is another parameter that can be varied and has a major influence on the size and distribution of the gas bubbles in the tank.

Also applying compression and decompression cycles can help, because pressure variation does not only generate bubbles but increases or decreases the bubble size by respectively decompression or compression. Furthermore, gradual decompression, i.e. releasing pressure in the tank in several steps, can be used to generate bubbles at different depths in the tank in order to achieve a better bubble distribution.

Another way is varying the range of bubble sizes over time. In that way, the period of time during which smaller bubbles are generated will finally deliver the desired range of size at smaller depth. The period of time during which bigger bubbles are generated will finally deliver the desired range of size at larger depth. Although the bubbles grow as they rise, a uniform bubble distribution is obtained in this way.

Also different gasses can be used. Different gases with different properties allow influencing the final bubble size distribution as well. For example, $N_2$ gas has a lower saturation level in pure wafer than $O_2$ gas. Thus $N_2$ will deliver gas bubbles more easily than $O_2$. If then $N_2$ gas is provided at smaller depth than the $O_2$, a region is created where, as the bubbles rise in the tank, the bubble size is approximately the same for both gasses. Optionally, more than 2 gasses can be used for further optimization.

Further, surfactants can be used to lower the surface tension of the liquid. The gas bubble size will increase then.

When using several transducers with different frequency a multiple frequency field will be created in the tank. In that way, a broader range of bubble sizes can be controlled with respect to cavitation. A megasonic field of 1 MHz affects bigger bubbles than one of 2 MHz. If the megasonic field of 1 MHz is supplied at smaller depth than the 2 MHz field, a broader range of bubble sizes will be affected in the same way, resulting in a broader region of uniform cavitation in the tank.

An additional acoustic field can be supplied at larger depth than the depth where the desired range of bubble size has to be achieved. In that way an additional acoustic field with the right specifications can make a particular range of bubbles collapse before entering the region where the final range of size is desired.

Furthermore, a set-up as shown in figure 6 can be used. An additional acoustic field at the bottom of the tank generated by a plurality of transducers with a same frequency is used to create bubbles with a particular range of size. At smaller depth in the tank another plurality of transducers with a same frequency is positioned such that the grown bubbles collapse. Because of the fixed liquid flow and the fixed distance (d) between a single transducer of the plurality of transducers at the bottom and the corresponding single transducer of the plurality of transducers at smaller depth, every bubble generated at a single transducer of the plurality of transducers at the bottom will grow in the same amount and will collapse by the acoustic field of the corresponding single transducer of the plurality of transducers at smaller depth.

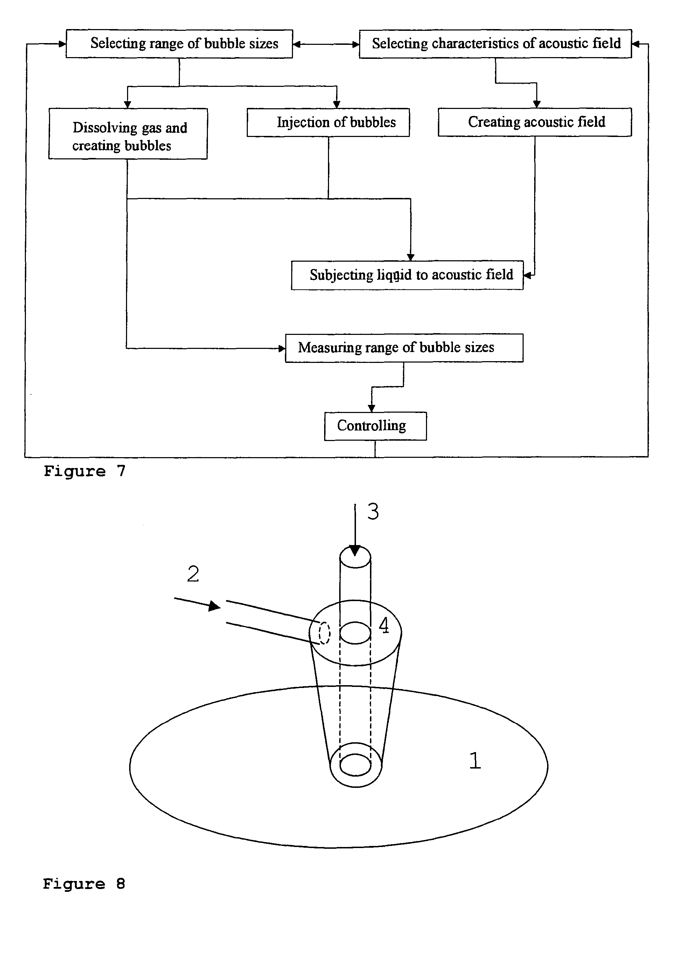

Figure 7 describes the process flow for a particular set-up according to the invention. First the characteristics of the acoustic field are selected, followed by the selection of the range of bubble sizes based on the Rayleigh-Plesset model. This can also be done in the opposite direction. This range of bubble sizes is created by dissolving gas in the liquid and creating bubbles or by immediate injection of gas bubbles in the liquid. If the selected acoustic field is created, the liquid with bubbles in the selected range of bubble sizes is subjected to it. After creating or injecting gas bubbles, the range of bubble sizes is measured by one of the measurement techniques as mentioned before. The results of the measurement are used to control the range and creation/injection of bubbles and/or the characteristics and creation of the acoustic field. In this way a feed-back loop process is created controlling cavitation in the liquid.

The invention as disclosed in this application can also be used in cases where the acoustic field is not generated in a tank containing the liquid. For example, in semiconductor applications, several batch and single wafer cleaning tools are known wherein a cleaning solution is applied on a rotating wafer and wherein the acoustic field is passed on to the cleaning solution via the wafer. Also single wafer cleaning tools are known where the cleaning solution is subjected to an acoustic field during supply by means of a megasonic or ultrasonic spray nozzle. This spray nozzle can be constructed as depicted in figure 8. A DIW supply (2) and a gas+DIW supply (3) are entering the nozzle. The transducer (4) is mounted in the top of the nozzle, surrounding the gas+DIW supply. In this set-up a mixture of DIW and gas, containing gas bubbles with the selected range of bubble size, has to be generated before entering the DIW+gas supply.

Another field of application can be sonochemistry. The method according to this invention can then be used to inject energy from collapsing bubbles in a controlled way in order to obtain a uniform catalytic effect resulting in a uniform reaction speed.

In ultrasound diagnostics, the bubble size and acoustic field can be optimized to enhance scattering of ultrasound by the bubbles resulting in a better contrast.

Example:

By means of the Young formula, which is based on the Rayleigh-Plesset model, the resonant radius of a bubble for a particular frequency can be calculated:

$$\omega_r^2 = \left( \frac{3\gamma P_0}{\rho R_0^2} \right)$$

If the frequency ($\varphi_r$) = 1.8 MHz and $\omega_r = 2\pi\varphi_r$, the adiabatic constant ($\gamma$) for oxygen = 1.4, the density ($\rho$) for DIW = 1000kg/m$^3$ and the hydrostatic pressure ($P_0$) at 0.25m depth = 103800 Pascal, then the resonant radius is 1.85$\mu$m. This means that in a 1.8MHz acoustic field, even at very low acoustic pressure (e.g. 0.1W/cm$^2$), the bubbles with a radius of 1.85$\mu$m will collapse. At higher acoustic pressure (e.g. 10W/cm$^2$), a broader range of bubbles sizes close to the resonant radius will collapse as well.

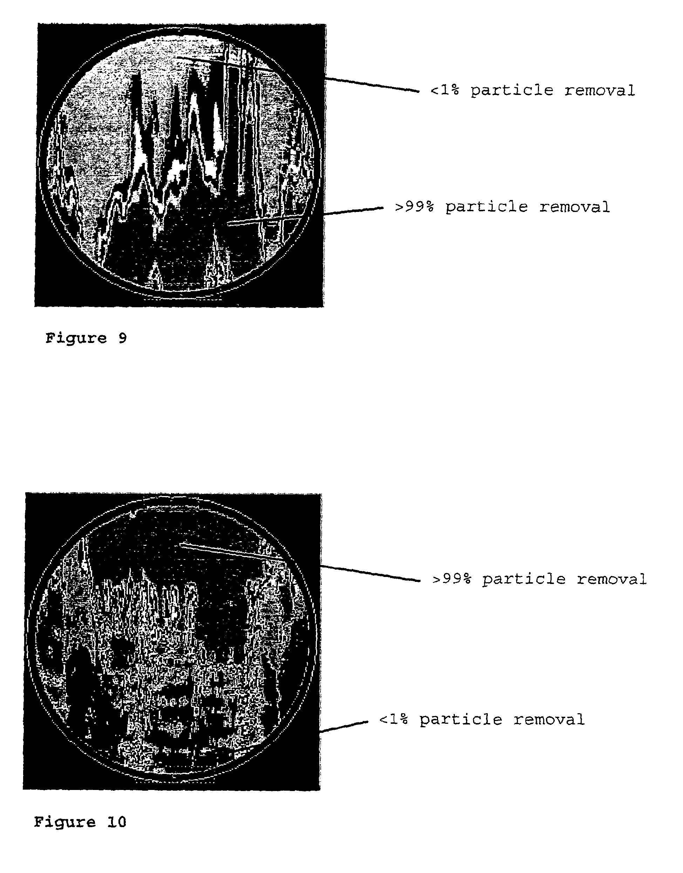

In a particular Techsonic wafer cleaning tank an acoustic field of 1.8 MHz and 5 W/cm$^2$ is generated. The water and gas supply system of the tank, working at 2.5 bar overpressure and containing 18ppm oxygen after passing a Mykrolis Phasor 2 gasification unit, gives a flow of 8SLM and fills the tank from the bottom (0.25m depth). The decompression step to 103800 Pascal, occurring at the inlet of the tank, results in a bubble size distribution close to the resonant radius at the bottom of the tank. The results of Particle Removal Efficiency (PRE) for 80nm SiO$_2$ particles on a silicon wafer, measured by the haze channel of the SP1DLS from KLA-Tencor, are given in figure 9. At the lower part of the wafer PRE is about 99%, where at the top part, PRE is only 1%.

When supplying water at the bottom of the tank containing only 10ppm oxygen, bubbles with a size below the resonant radius are generated. As they rise in the tank, they will grow due to the change in hydrostatic pressure and rectified diffusion till they reach a bubble size distribution close to the resonant radius. In this case the results of PRE are given in figure 10. At the lower part of the wafer PRE is only 1% where at the top part, PRE is about 99%.

**Claims**

1. A method for creating cavitation comprising the steps of

   - creating gas bubbles having a range of bubble sizes in a liquid,
   - creating an acoustic field and
   - subjecting the liquid to the acoustic field,
   **characterized in that** the range of bubble sizes and/or the characteristics of the acoustic field are selected to tune them to each other, thereby controlling cavitation in the selected range of bubble sizes.

2. A method according to claim 1 **characterized in that** the range of bubble sizes is selected subsequent to and depending on the selection of the characteristics of the acoustic field.

3. A method according to claim 1 **characterized in that** the characteristics of the acoustic field are selected subsequent to and depending on the selected range of bubble sizes.

4. A method according to claim 1 **characterized in that** the step of creating gas bubbles having a selected range of bubble sizes comprises dissolving gas in the liquid by means of a gasification unit or any means to dissolve gas in the liquid.

5. A method according to claim 1 **characterized in that** the step of creating gas bubbles having a selected range of bubble sizes comprises injection of gas in the liquid by means of a bubbler system, a capillary, a nozzle, a membrane contactor or any means to inject gas bubbles into the liquid.

6. A method according to claim 1 **characterized in that** the step of creating gas bubbles having a selected range of bubble sizes comprises a pressure drop or comprises one or multiple compression/decompression cycles.

7. A method according to claim 1 **characterized in that** the step of creating gas bubbles having a selected range of bubble sizes comprises a raise in temperature or comprises one or multiple cycles of heating/cooling the liquid.

8. A method according to claim 1 **characterized in that** the step of creating gas bubbles having a selected range of bubble sizes comprises a step of subjecting the liquid to a an additional acoustic field.

9. A method according to claim 1 **characterized in that** the step of creating gas bubbles having a selected range of bubble sizes comprises dissolving or injecting two or more different gasses into the liquid.

10. A method according to claim 1 **characterized in that** the step of creating gas bubbles having a selected range of bubble sizes comprises adding a surfactant to the liquid.

11. A method according to claim 1 **characterized in that** the range of bubble sizes is varied over time.

12. A method according to claim 1 **characterized in that** the acoustic field comprises one or more frequencies.

13. A method according to claim 1, further comprising the step of measuring the range of bubble sizes.

14. A method according to claim 13, further comprising the step of controlling the characteristics of the acoustic field subsequently to and dependent on the measurement.

15. A method according to claim 13, further comprising the step of controlling the range of bubble sizes subsequently and dependent on the measurement.

16. A method according to any of the above claims, **characterized in that** it is used for cleaning semiconductor substrates.

**17.** An apparatus comprising

- means for creating gas bubbles having a range of bubble sizes in a liquid,
- means for creating an acoustic field and
- means for subjecting the liquid to the acoustic field,
**characterized in that** the means for creating the gas bubbles having a range of bubble sizes and/or the means for creating the acoustic field are designed to tune the range of bubble sizes and the characteristics of the acoustic field to each other, thereby controlling cavitation in the selected range of bubble sizes.

**18.** An apparatus according to claim 17 **characterized in that** the means for creating gas bubbles having a range of bubble sizes comprise a gasification unit or any means to dissolve gas in the liquid.

**19.** An apparatus according to claim 17 **characterized in that** the means for creating gas bubbles having a range of bubble sizes comprise a valve, a nozzle, a membrane contactor or any means to inject gas bubbles into the liquid.

**20.** An apparatus according to claim 17 **characterized in that** the means for creating gas bubbles having a range of bubble sizes comprise a heat exchanging system or any means for heating/cooling the liquid.

**21.** An apparatus according to claim 17 **characterized in that** the means for creating gas bubbles having a range of bubble sizes comprise any means for generating a pressure drop or generating one or multiple compression/decompression cycles.

**22.** An apparatus according to claim 17 **characterized in that** the means for creating gas bubbles having a range of bubble sizes comprise means to create an additional acoustic field and to subject the liquid to the additional acoustic field.

**23.** An apparatus according to claim 17 **characterized in that** the means for creating gas bubbles having a range of bubble sizes comprise means for dissolving or injecting two or more different gasses into the liquid.

**24.** An apparatus according to claim 17 **characterized in that** the means for creating gas bubbles having a range of bubble sizes comprise means for adding a surfactant to the liquid.

**25.** An apparatus according to claim 17 **characterized in that** the means for creating an acoustic field are capable of generating one or more frequencies.

**26.** An apparatus according to claim 17 further comprising a measurement unit for measuring the range of bubble sizes.

**27.** An apparatus according to claim 17 further comprising a control unit for controlling the means for creating gas bubbles having a range of bubble sizes and/or controlling the means for creating an acoustic field.

**28.** An apparatus according to claim 17 to 27, **characterized in that** it is used for cleaning semiconductor substrates.

Figure 1

Figure 2

Figure 3

Figure 4

Figure 5

Figure 6

Figure 7

Figure 8

<1% particle removal

>99% particle removal

Figure 9

>99% particle removal

<1% particle removal

Figure 10

**European Patent Office**

**EUROPEAN SEARCH REPORT**

Application Number

EP 04 44 7204

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 931 173 A (SCHIELE) 3 August 1999 (1999-08-03) | 1,3-7, 10, 12-21, 24-28 | B08B3/12 B01J19/10 H01L21/00 |
| Y | | 8,9,11, 22,23 | |
| | * abstract * * column 1, line 6 - column 2, line 47 * * column 3, line 14 - column 7, line 53 * * column 10, line 3 - line 14 * * column 11, line 16 - column 13, line 57 * * column 14, line 14 - line 42 * * figures * ----- | | |
| Y | US 5 681 396 A (MADANSHETTY) 28 October 1997 (1997-10-28) | 8,11,22 | |
| A | | 1,3,12, 16,17, 25,27,28 | |
| | * abstract * * column 1, line 11 - line 15 * * column 2, line 10 - line 24 * * column 3, line 30 - column 4, line 67 * * column 6, line 61 - column 8, line 32 * * column 8, line 66 - column 10, line 25 * * figures * ----- -/-- | | TECHNICAL FIELDS SEARCHED (Int.Cl.7) B08B H01L B01J |

The present search report has been drawn up for all claims

| Place of search | Date of completion of the search | Examiner |
|---|---|---|
| The Hague | 11 February 2005 | van der Zee, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 637 238 A1**

European Patent
Office

**EUROPEAN SEARCH REPORT**

Application Number

EP 04 44 7204

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,Y | US 6 048 405 A (SKROVAN ET AL) 11 April 2000 (2000-04-11) | 9,23 | |
| A | | 1,5,12, 16,17, 19,25,28 | |
| | * abstract * <br> * column 1, line 9 - line 13 * <br> * column 1, line 38 - line 49 * <br> * column 2, line 40 - column 3, line 19 * <br> * column 4, line 1 - column 7, line 41 * <br> * figures * <br> ----- | | |
| X | DE 43 05 660 A (MAYER) 30 September 1993 (1993-09-30) | 1,3,5, 12,17, 19,25,27 | |
| A | * the whole document * <br> ----- | 7,20 | |
| X | EP 0 860 866 A (INTERNATIONAL BUSINESS MACHINES CORP. ET AL) 26 August 1998 (1998-08-26) | 1-7,10, 12, 16-21, 24,25, 27,28 | |
| | | | TECHNICAL FIELDS SEARCHED (Int.Cl.7) |
| | * abstract * <br> * page 2, line 3 - line 4 * <br> * page 2, line 40 - page 3, line 3 * <br> * page 3, line 34 - line 54 * <br> * page 4, line 29 - line 49 * <br> * page 5, line 10 - line 41 * <br> * figure * <br> ----- <br> -/-- | | |

The present search report has been drawn up for all claims

| Place of search | Date of completion of the search | Examiner |
|---|---|---|
| The Hague | 11 February 2005 | van der Zee, W |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

## EUROPEAN SEARCH REPORT

Application Number

EP 04 44 7204

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 5 961 895 A (SANFORD) 5 October 1999 (1999-10-05) <br><br> * abstract * <br> * column 1, line 13 - line 17 * <br> * column 1, line 41 - column 2, line 20 * <br> * column 2, line 61 - column 3, line 35 * <br> * column 4, line 5 - line 53 * <br> * figures * <br> ----- | 1,4-6, 10,11, 17-19, 21,24 | |
| A | US 5 437 729 A (BOATNER ET AL) 1 August 1995 (1995-08-01) <br><br> * column 1, line 25 - line 45 * <br> * column 2, line 13 - line 46 * <br> * column 3, line 34 - line 53 * <br> * column 4, line 59 - line 68 * <br> * column 6, line 58 - column 7, line 61 * <br> * column 8, line 33 - line 48 * <br> * figure 1 * <br> ----- | 1,3,10, 12,16, 17,24, 25,27,28 | TECHNICAL FIELDS SEARCHED (Int.Cl.7) |

The present search report has been drawn up for all claims

| Place of search | Date of completion of the search | Examiner |
|---|---|---|
| The Hague | 11 February 2005 | van der Zee, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 04 44 7204

This annex lists the patent family members relating to the patent documents cited in the above-mentioned European search report.
The members are as contained in the European Patent Office EDP file on
The European Patent Office is in no way liable for these particulars which are merely given for the purpose of information.

11-02-2005

| Patent document cited in search report | | Publication date | Patent family member(s) | | Publication date |
|---|---|---|---|---|---|
| US 5931173 | A | 03-08-1999 | NONE | | |
| US 5681396 | A | 28-10-1997 | AU | 4771896 A | 14-08-1996 |
| | | | WO | 9622844 A1 | 01-08-1996 |
| US 6048405 | A | 11-04-2000 | US | 5849091 A | 15-12-1998 |
| | | | US | 6006765 A | 28-12-1999 |
| DE 4305660 | A | 30-09-1993 | DE | 4305660 A1 | 30-09-1993 |
| EP 0860866 | A | 26-08-1998 | US | 5800626 A | 01-09-1998 |
| | | | EP | 0860866 A1 | 26-08-1998 |
| | | | JP | 3117427 B2 | 11-12-2000 |
| | | | JP | 10242107 A | 11-09-1998 |
| | | | TW | 409305 B | 21-10-2000 |
| US 5961895 | A | 05-10-1999 | NONE | | |
| US 5437729 | A | 01-08-1995 | NONE | | |

EPO FORM P0459

For more details about this annex : see Official Journal of the European Patent Office, No. 12/82